# EUROPEAN PATENT APPLICATION

(11) **EP 2 628 823 A2**
(43) Date of publication of application: **21.08.2013**
(21) Application number: 12173216.8
(22) Date of filing: 22.06.2012
(51) Int. Cl.: C23C 16/455, C23C 16/458

(54) **Chemical vapour deposition apparatus**

(30) Priority: 17.02.2012 TW 101105377
(71) Applicant: Pinecone Material Inc, Taipei City 110 (TW)
(72) Inventor: Liu, Heng, Sunnyvale, CA 94087 (US); Liu, Nien-Tzu, Taipei City 115 (TW); Yang, Cheng Chieh, Taoyuan City 330 (TW)
(74) Representative: Baldwin, Mark

(57) **Abstract**

A chemical vapour deposition (CVD) apparatus is described that includes a susceptor located in a reaction chamber. The susceptor has a first surface for supporting a wafer. The apparatus also includes a heater located in the reaction chamber and facing a second surface of the susceptor. The heater heats the susceptor and provides a temperature to the wafers for the CVD reaction. The first surface of the susceptor is opposite to the second surface of the susceptor. A showerhead is located between the susceptor and the cap. The showerhead provides a reaction gas to the susceptor. A cooling module is integrated with the showerhead. The cooling module provides cooling fluid that cools the showerhead.

## Description

### BACKGROUND OF THE INVENTION

### 1. FIELD OF THE INVENTION

The present invention generally relates to a chemical vapour deposition (CVD) apparatus with a cooling module integrated into a showerhead.

### 2. DESCRIPTION OF RELATED ART

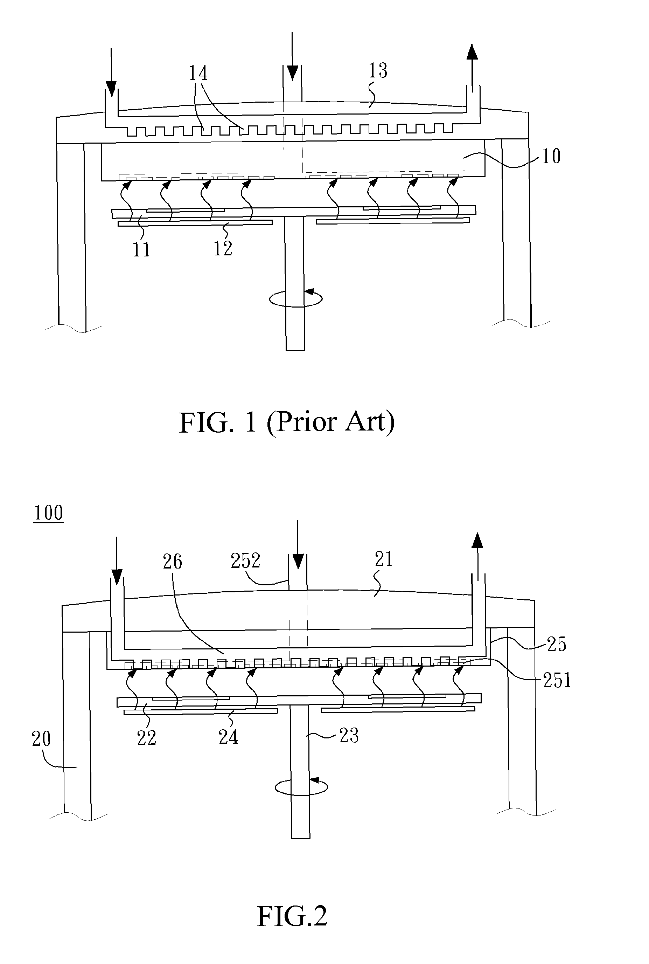

Chemical vapour deposition (CVD) is one process used in the semiconductor industry to produce a thin film. FIG. 1 schematically shows a cross section of a conventional CVD apparatus. Reaction gas is provided to a wafer supported on a susceptor 11 via a showerhead 10. Further, a heater 12 placed below the susceptor 11 is used to heat the susceptor in order to provide a temperature suitable for a CVD reaction. The heat generated by the heater 12, however, causes disadvantages to the showerhead 10. Therefore, a cooling channel 14 is typically provided in the cap 13 to cool the showerhead 10. As the surface of the showerhead 10 facing the heater 12 has a temperature higher than the opposite surface that faces the cap 13, there is a temperature gradient between the two surfaces, which generates thermal stresses that warp the showerhead. The warped showerhead 10 compresses and thereby deforms the abutting cap 13, causing leakage in the CVD apparatus.

Accordingly, a need has arisen for a novel CVD apparatus that reduces or inhibits the disadvantages described above or is at least an alternative to existing apparatus.

### SUMMARY

In certain embodiments, a chemical vapour deposition (CVD) apparatus is capable of reducing a temperature gradient of a showerhead, substantially minimising warping of the showerhead, and/or preventing deformation of a cap and consequent leakage in the CVD apparatus.

In certain embodiments, a CVD apparatus includes a chamber wall, a cap, a susceptor, a heater, a showerhead, and a cooling module. The chamber wall and the cap define a reaction chamber for performing a CVD reaction. The susceptor is located in the reaction chamber and has a first surface for supporting a wafer. The heater is located in the reaction chamber and faces a second surface of the susceptor. The heater provides heat to the susceptor during use to heat the susceptor to a temperature suitable for a CVD reaction to occur on at least one wafer on the susceptor. The first surface of the susceptor is opposite to the second surface of the susceptor. The showerhead is located between the susceptor and the cap in the reaction chamber to provide reaction gas to the susceptor. The cooling module is integrated with the showerhead to provide cooling fluid that cools the showerhead.

In certain embodiments a method of forming a product by chemical vapour deposition comprises supplying a reaction gas to a reaction chamber by channelling said reaction gas through a showerhead from which the reaction gas is output into said reaction chamber and cooling said showerhead by channelling a cooling fluid through said showerhead separately of the channelling of the reaction gas.

### BRIEF DESCRIPTION OF THE DRAWINGS

FIG. 1 is a schematic cross section of a conventional CVD apparatus.
FIG. 2 is a schematic cross section of an embodiment of a CVD apparatus.
FIG. 3 is a schematic cross section of another embodiment of a CVD apparatus.
FIG. 4 is a schematic cross section of yet another embodiment of a CVD apparatus.
FIG. 5A is a schematic cross section of an embodiment of a showerhead.
FIG. 5B shows a partially enlarged cross section of FIG. 5A.
FIG. 5C shows a partially enlarged perspective view of FIG. 5A.

### DETAILED DESCRIPTION

FIG. 2 is a schematic cross section of an embodiment of chemical vapour deposition (CVD) apparatus 100. The CVD apparatus 100 may be, but is not limited to, a metal organic chemical vapour deposition (MOCVD) apparatus. Although a horizontal CVD apparatus is exemplified in the following embodiments, any embodiment of the apparatus may be adapted to be a vertical CVD apparatus. Up and down directions in the horizontal CVD apparatus would be left and right directions in the vertical CVD apparatus. CVD apparatus 100 may provide a reaction chamber for performing a CVD reaction such as an epitaxial deposition reaction. The reaction chamber of the apparatus 100 is defined by a chamber wall 20 and a cap 21. In the CVD apparatus, the cap 21 covers the chamber wall 20 to form an air-tight space. In certain embodiments, the susceptor 22 is placed in the reaction chamber of the CVD apparatus 100. The susceptor 22 has a first surface (eg a top surface as shown in FIG. 2) that is used to support a wafer or wafers. The susceptor 22 has a second surface (eg a bottom surface as shown in FIG. 2), which is coupled to (eg affixed to) a pillar 23 that supports and rotates the susceptor 22. The first surface and the second surface of the susceptor 22 are opposite to each other. A heater 24 faces the second surface of the susceptor 22 and surrounds the pillar 23. The heater 24 heats the susceptor 22 to a temperature suitable for the CVD reaction to occur on the wafer or wafers on the susceptor.

In certain embodiments, a showerhead 25 is placed in the reaction chamber and is placed between the susceptor 22 and the cap 21. The showerhead 25 includes a number of nozzles 251 facing the first surface of susceptor 22. Reaction gas enters the CVD apparatus 100 through a first end of a reaction gas channel 252 that passes through the cap 21. The reaction gas exits from a second end of the reaction gas channel 252 and goes to the showerhead 25. The reaction gas is then provided to the susceptor 22 via the nozzles 251. Although the reaction gas channel 252, as shown in FIG. 2, passes through the cap 21 to enter the reaction chamber, the reaction gas channel may instead, for example, pass through the chamber wall 20 to enter the reaction chamber.

In certain embodiments, a cooling water channel 26 is placed in the reaction chamber of CVD apparatus 100. In some embodiments, the cooling water channel 26 is integrated into the showerhead 25 to be near a surface of the showerhead facing the susceptor 22. In an embodiment, the cooling water channel 26 is near the nozzles 251 and spaced from the cap 21 (eg the cooling water channel is closer to the nozzles than it is to the cap). In some embodiments, the cooling water channel 26 is interlaced with the nozzles 251. Cooling water enters a first end of the cooling water channel 26, passes through the cap 21, and flows through the showerhead 25. The cooling water then passes through the cap 21 again and finally exits from a second end of the cooling water channel 26, thereby cooling the showerhead 25. Although the cooling water channel 26, as shown in FIG. 2, passes through the cap 21 to enter showerhead 25, the cooling water channel may, for example, pass through the chamber wall 20 instead.

The cooling water flowing through the cooling water channel 26 is capable of transferring heat away from showerhead 25 to provide thermal shielding to reduce the temperature gradient in the showerhead. Reducing the temperature gradient may substantially minimise warping of the showerhead 25 and inhibit deformation of the cap 21 and, thereby, leakage from the CVD apparatus 100. Although a cooling water channel 26 is shown in the embodiment of the CVD apparatus 100 depicted in FIG. 2, other cooling modules that provide cooling fluid to the showerhead 25 may also be used. In some embodiments, the cooling water is replaced by other cooling fluids, such as a cooling gas.

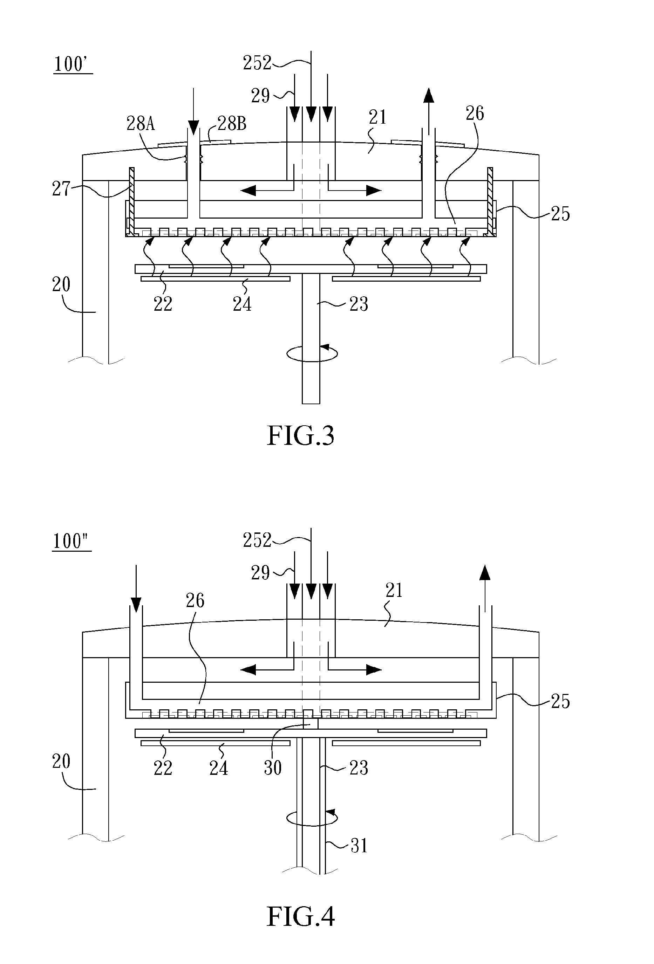

FIG. 3 is a schematic cross section of an embodiment of a CVD apparatus 100'. The CVD apparatus 100' is similar to the CVD apparatus 100 (shown in FIG. 2) with the exception that, in the CVD apparatus 100', the showerhead 25 is separated (spaced) from the cap 21 by a selected distance to form a space between the showerhead and the cap. In such embodiments, even if the showerhead 25 is warped or becomes warped, the showerhead will not compress and thereby deform cap 21. In some embodiments, a purge gas channel 29 is provided in the reaction chamber. Purge gas (eg nitride gas) may enter a first end of a purge gas channel 29 and exit from a second end of the purge gas channel to flow into the space between the showerhead 25 and the cap 21 to prevent unwanted deposition in the space (eg magnesium deposition). In certain embodiments, the purge gas channel 29 passes through the centre of the cap 21 and the purge gas exiting from the second end of the purge gas channel 29 flows radially outwards from the centre of the cap 21 (or showerhead 25).

In certain embodiments, the showerhead 25 is fastened to the cap 21 or the chamber wall 20 via screw bolts 27. In addition to fastening the showerhead 25, the screw bolts 27 may extend out of the cap 21 or chamber wall 20, for adjusting the elevation and levelling of the showerhead. In some embodiments at least one O-ring 28A (eg double O-rings) is used to create a seal between the cooling water channel 26 and the cap 21 (or between the cooling water channel and the chamber wall 20). In some embodiments, at least one packing ring 28B is used to surround a portion of the cooling water channel 26 that passes into the cap 21 (or chamber wall 20) to provide a seal.

FIG. 4 is a schematic cross section of an embodiment of a CVD apparatus 100". The CVD apparatus 100" is similar to the CVD apparatus 100' (shown in FIG. 3) with the exception that, in the CVD apparatus 100", a supporting member 30 (eg an axle member) may be coupled to (eg affixed to) the showerhead 25 at one end and extend to engage the pillar 23 at the other end. As shown in FIG. 4, the pillar 23 is not fixed with respect to the susceptor 22. A sleeve 31 surrounding the pillar 23 may be coupled to (eg affixed to) the susceptor 22 and used to rotate the susceptor.

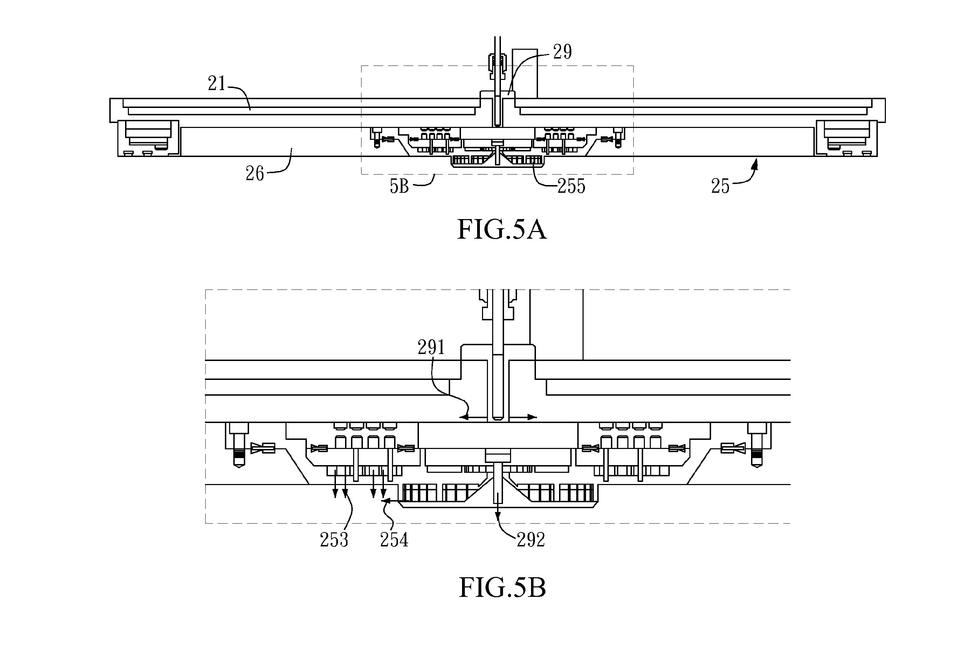

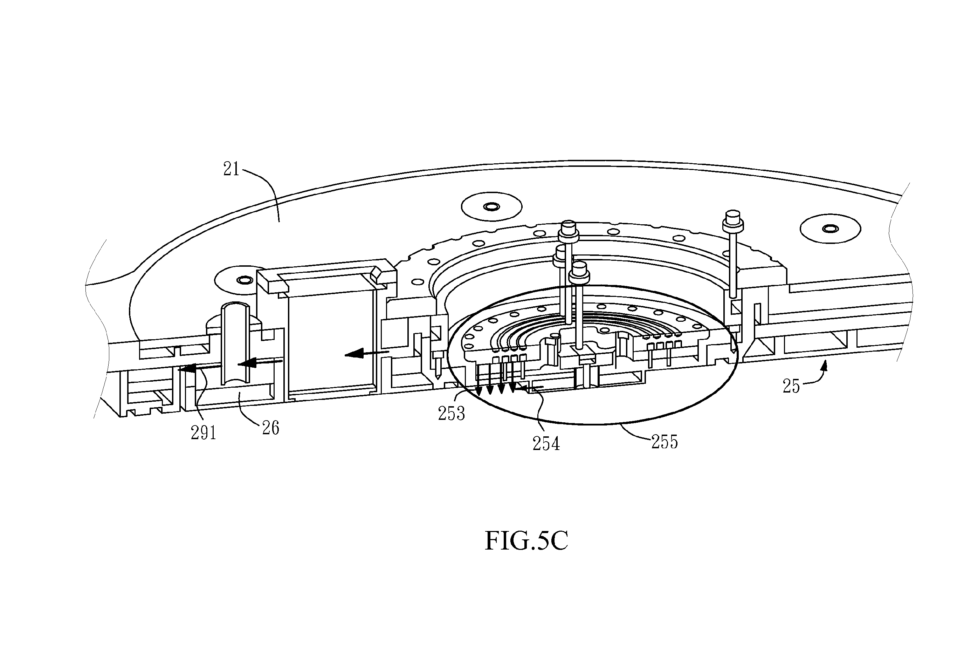

FIG. 5A is a schematic cross section of an embodiment of the showerhead 25. FIG. 5B shows a partially enlarged cross section of FIG. 5A and FIG. 5C shows a partially enlarged perspective view of FIG. 5A. In certain embodiments, the showerhead 25 includes a gas supply module 255 and a cooling water channel 26. The gas supply module 255 may be placed approximately at a centre of the showerhead 25. The cooling water channel 26 may surround the gas supply module 255 to provide thermal shielding. A first portion of a reaction gas 253 flows from the gas supply module 255 towards the susceptor (not shown) and a second portion of the reaction gas 254 flows radially outwardly from the gas supply module so that the first portion of the reaction gas may be carried (distributed) throughout the reaction chamber.

In certain embodiments, a space exists between the showerhead 25 and the cap 21. The purge gas enters from one end of purge gas channel 29. A portion of the purge gas 291 flows into the space between the showerhead 25 and the cap 21. Another portion of the purge gas 292 flows to the susceptor through showerhead 25. The purge gas portions 291, 292 may be conducted via separate purge gas channels, or via a single purge gas channel and be separated using a valve.

In certain embodiments, the surface of the cooling water channel 26, particularly the surface facing the susceptor, may include a thermal-shield (thermally insulating) material (eg ceramic) with high thermal resistivity in order to increase thermal shielding efficiency.

It is to be understood the invention is not limited to particular systems described which may, of course, vary. It is also to be understood that the terminology used herein is for the purpose of describing particular embodiments only, and is not intended to be limiting. As used in this specification, the singular forms "a", "an" and "the" include plural referents unless the content clearly indicates otherwise. Thus, for example, reference to "a device" includes a combination of two or more devices and reference to "a material" includes mixtures of materials.

Further modifications and alternative embodiments of various aspects of the invention will be apparent to those skilled in the art in view of this description. Accordingly, this description is to be construed as illustrative only and is for the purpose of teaching those skilled in the art the general manner of carrying out the invention. It is to be understood that the forms of the invention shown and described herein are to be taken as the presently preferred embodiments. Elements and materials may be substituted for those illustrated and described herein, parts and processes may be reversed, and certain features of the invention may be utilized independently, all as would be apparent to one skilled in the art after having the benefit of this description of the invention. Changes may be made in the elements described herein without departing from the spirit and scope of the invention as specified in the following claims.

## Claims

1. A chemical vapour deposition (CVD) apparatus, comprising:
a chamber wall (20) and a cap (21) that at least partially defines a reaction chamber;
a susceptor (22) located in the reaction chamber, the susceptor having a first surface for supporting one or more wafers and a second surface disposed opposite the first surface;
a heater (24) located in the reaction chamber and facing said second surface of the susceptor for heating the susceptor;
a showerhead (25) located between the susceptor and the cap from which, in use, a reaction gas is supplied to the susceptor; and
a cooling module integrated with the showerhead for fluid cooling the showerhead.

2. The CVD apparatus of claim 1, further comprising a pillar (23) coupled to the second surface of the susceptor (22) for supporting and rotating the susceptor.

3. The CVD apparatus of claim 1, further comprising:
a pillar (23) having a first end coupled to the reaction chamber;
a supporting member (30) having a first end coupled to the showerhead and a second end coupled to a second end of the pillar; and
a rotatable sleeve (31) surrounding the pillar and coupled to the susceptor (22) to rotate the susceptor.

4. The CVD apparatus of claim 1, 2 or 3, wherein a surface of the showerhead (25) that faces the susceptor (22) is provided with a plurality of nozzles (251) from which said reaction gas is supplied to the receptor.

5. The CVD apparatus of claim 4, wherein the cooling module is located closer to the nozzles (251) than to the cap (21).

6. The CVD apparatus of claim 4 or 5, wherein the cooling module is interlaced with the nozzles (251).

7. The CVD apparatus of claim 1, 2 or 3, wherein the showerhead (25) comprises a reaction gas supply module located approximately at a centre of the showerhead and the cooling module surrounds the reaction gas supply module to provide thermal shielding.

8. The CVD apparatus of claim 7, wherein the reaction gas supply module has at least one first outlet configured such that a first portion of the reaction gas flows from the gas supply module towards the susceptor and at least one second outlet configured such that a second portion of the reaction gas flows radially outwardly from the gas supply module across the path of the first portion of the reaction gas.

9. The CVD apparatus of claim 1, 2 or 3, wherein the showerhead (25) comprises a reaction gas module and a purge gas channel and is spaced from the cap (21) to define a space therebetween, the arrangement being such that, in use, a first purge gas portion can flow from the purge gas channel into the space between the showerhead and the cap under control of a valve and a second purge gas portion can flow to the susceptor through the showerhead.

10. The CVD apparatus of any one of claims 1 to 8, wherein the showerhead (25) is spaced from the cap (21) a selected distance to form a space between the showerhead and the cap.

11. The CVD apparatus of claim 9 or 10, further comprising a purge gas channel (29) for supplying purge gas to the space between the showerhead (25) and the cap (21).

12. The CVD apparatus of claim 11, wherein the purge gas channel (29) passes through a centre of the cap (21), and is arranged such that at least a portion of the purge gas exiting the purge gas channel flows radially outwardly from the centre of the showerhead.

13. The CVD apparatus of any one of the preceding claims, wherein a surface of the cooling module comprises a thermally insulating material.

14. The CVD apparatus of claim 13, wherein the thermally insulating material comprises a ceramic.

15. The CVD apparatus of any one of the preceding claims, further comprising at least one screw bolt (27) for fastening the showerhead (25) to the cap (21) or the chamber wall (20) and adjusting the elevation and levelling the showerhead.
